# EUROPÄISCHE PATENTANMELDUNG

(11) **EP 1 432 299 A2**
(43) Veröffentlichungstag der Anmeldung: **23.06.2004**
(21) Anmeldenummer: 03104416.7
(22) Anmeldetag: 27.11.2003
(51) Int. Cl.: H05K 13/04

(54) **Verfahren und Vorrichtung zum partiellen Aufbringen von Klebstoff auf Bauelemente und Bestückvorrichtung zum Bestücken von Bauelementen**

(30) Priorität: 16.12.2002 DE 10258798
(71) Anmelder: SIEMENS AKTIENGESELLSCHAFT, 80333 München (DE)
(72) Erfinder: Schiebel, Günter, 81379, München (DE)

(57) **Zusammenfassung**

Die Erfindung schafft ein Verfahren und eine Vorrichtung zum partiellen Aufbringen von Klebstoff auf Bauelemente, insbesondere auf elektronische Bauelemente wie Flip Chips und/oder Ball Grid Arrays. Dabei wird zumindest ein Transfer-Element (141) verwendet, welches zunächst eine Klebstoffschicht (130), die auf einem Trägerelement (120) ausgebildet ist, durchdringt und dabei an seiner Frontseite Klebstoff (131) aufnimmt. Bei einer Berührung zwischen einem Bauelement 100 und dem Transfer-Element (141) wird zumindest ein Teil des zuvor aufgenommenen Klebstoffs (131) auf das Bauelement (100) übertragen. Gemäß einem vorteilhaften Ausführungsbeispiel der Erfindung werden eine Mehrzahl von als Stifte ausgebildete Transfer-Elemente (141) eingesetzt, so dass Klebstoff (131) gleichzeitig an verschiedenen Stellen auf ein Bauelement (100) übertragen werden kann. Die Erfindung schafft ferner eine Bestückvorrichtung zum Bestücken von Bauelementen (200), bei der die Bauelemente (200) zunächst mittels einer Vorrichtung (280) zum partiellen Aufbringen von Klebstoff behandelt und nachfolgend auf einem Bauelementeträger (260) aufgesetzt werden.

## Beschreibung

Die Erfindung betrifft ein Verfahren sowie eine Vorrichtung zum partiellen Aufbringen von Klebstoff auf Bauelemente, insbesondere auf elektronische Bauelemente wie Flip Chips und/oder Ball Grid Arrays. Die Erfindung betrifft ferner eine Bestückvorrichtung zum Bestücken derartiger Bauelemente auf einem Bauelementeträger.

Die Miniaturisierung von elektronischen Baugruppen, d.h. der Aufbau von elektronischen Schaltungen auf möglichst geringem Raum, beruht unter anderem darauf, dass hochintegrierte elektronische Bauelemente mit einer Vielzahl von elektrischen Anschlüssen verwendet werden, welche nicht nur seitlich des Bauelements angeordnet sondern über eine flächige Unterseite des Bauelements verteilt sind. Dies ermöglicht auf geringem Raum eine Vielzahl von elektrischen Kontaktierungen zwischen einem Bauelement und einem Bauelementeträger. Bauelementeträger sind beispielsweise Leiterplatten oder Substrate.

Im folgenden werden unter dem Begriff Bauelemente alle bestückfähigen Elemente verstanden, insbesondere elektronische Bauelemente, elektromechanische Bauelemente, Stecker und Steckverbindungen für elektrische und mechanische Kontakte sowie Abschirmbleche. Der Begriff elektronische Bauelemente umfasst selbst eine Vielzahl von verschiedenen Bauelementen, beispielsweise optoelektronische Bauelemente, SMD-Bauelemente (Surface Mount Device-Bauelemente) und hochintegrierte flächige Bauelemente. Dazu zählen beispielsweise Bare Dies, Flip Chips, Ball Grid Arrays und RFID-Bauelemente, welche für sog. Transponder verwendet werden.

Ein Problem bei der Bestückung insbesondere von flächigen Bauelementen besteht darin, dass das bestückte Bauelement gegenüber dem Bauelementeträger ein bestimmtes Klebevermögen aufweisen muss, damit es auf dem Bauelementeträger nicht verrutscht und bei einem nachfolgenden Lötvorgang exakt in der vorgegebenen Bestückposition verlötet wird. Nur dann ist ein sicherer elektrischer Kontakt zwischen den Anschlüssen des Bauelements und den auf dem Bauelementeträger vorgesehenen Anschlussflächen gewährleistet.

Zur räumlichen Fixierung von bestückten Bauelementen auf einem Bauelementeträger werden deshalb klebrige Substanzen eingesetzt, die eine stabile räumliche Lage zumindest bis zu dem nachfolgenden Lötvorgang gewährleisten.

Ein derartiges Fixieren der Bauelemente auf dem Bauelementeträger ist unter anderem bei sog. Flip Chips und/oder Ball Grid Arrays erforderlich. Der Klebestoff besteht in diesem Fall häufig aus Lotpaste und eventuell aus einem Flussmittel, welches eine nachfolgende Verlötung des Bauelements erleichtert.

An dieser Stelle wird darauf hingewiesen, dass der Begriff Ball Grid Array neben herkömmlichen Ball Grid Arrays auch sog. Chip Scale Packages bzw. Micro Ball Grid Arrays umfasst.

Aus der WO 1999/18766 ist ein Verfahren zum Bestücken von Halbleiterbauelementen auf Schaltungsträgern bekannt, bei dem ein Klebstoff in Form von einzelnen Tropfen auf einem Schaltungsträger aufgebracht wird und somit das Bauelement an einer oder an mehreren Stellen mit dem Schaltungsträger verklebt wird. Zur Erzeugung einer flächigen Klebstoffschicht wird der Schaltungsträger derart in Rotation versetzt, dass der Klebstofftropfen infolge der Zentrifugalkraft radial nach außen zerfließt. Dieses Verfahren hat jedoch den Nachteil, dass zur Erzeugung einer flächigen Klebstoffschicht der Schaltungsträger einer aufwendigen und langwierigen Behandlung unterzogen werden muss, so dass die Herstellungskosten entsprechend hoch sind.

Im Zusammenhang mit der Bestückung von Flip Chips bzw. Ball Grid Arrays ist ferner bekannt, dass die Bauelemente kurzzeitig auf einen klebrigen Film aus Flussmittel oder Klebstoff abgesenkt werden. Die Schichtdicke der Klebstoffschicht ist dabei derart gewählt, dass auf keinen Fall die gesamte Bauelementunterseite sondern nur die Anschlusskugeln mit dem Klebstoff benetzt werden. Dies wird dadurch erreicht, dass für die Schichtdicke der Klebstoffschicht eine Dicke gewählt wird, die ungefähr so groß ist wie der halbe Durchmesser der Anschlusskugeln. In diesem Fall ist das Herausheben der Bauelemente aus dem klebrigen Film unproblematisch, da nur die Anschlusskugeln, d.h. ein sehr kleiner Teile der flächigen Bauelementunterseite mit dem Klebstoff benetzt ist.

Eine flächige Benetzung der Unterseite eines Bauelements mit Klebstoff würde mit hoher Wahrscheinlichkeit dazu führen, dass das Bauelement nicht von der Klebstoffschicht entfernt werden kann, da die im allgemeinen mittels Vakuum erzeugte Haltekraft einer Haltevorrichtung für das Bauelement nicht ausreicht, um die Klebekraft zwischen der Klebstoffschicht und dem Bauelement zu überwinden.

Das o.g. Verfahren, bei dem die Bauelemente kurzzeitig auf einen klebrigen Film aus Flussmittel oder Klebstoff abgesenkt werden, eignet sich jedoch nicht für sog. Wafer Level Underfilled Packages. Dies sind Bauelemente wie beispielsweise Flip Chips und/oder Ball Grid Arrays, die an ihrer flächigen Unterseite mit einer vorgehärteten Klebstoffschicht versehen sind. Diese Klebstoffschicht dient dazu, dass die Bauelemente bei einem Lötvorgang in einem Ofen durch ein temporäres Aufschmelzen der Klebstoffschicht fest mit dem Bauelementeträger verklebt werden, so dass mechanische Spannungen, die insbesondere auf unterschiedlichen thermischen Ausdehnungskoeffi zienten von Bauelement und Bauelementeträger beruhen, aufgefangen werden. Da bei Wafer Level Underfilled Packages die Anschlusskugeln kaum aus der Underfill-Klebstoffschicht herausragen, wird bei einem kurzzeitigen Absenken eines derartigen Bauelements auf einen klebrigen Film stets die ganze Bauelement-Unterseite mit Klebstoff benetzt, so dass die Haltekraft der Haltevorrichtung im allgemeinen nicht ausreicht, um das flächig benetzte Bauelement wieder von der Klebstoffschicht zu entfernen.

Der Erfindung liegt somit die Aufgabe zugrunde, ein Verfahren sowie eine Vorrichtung zum partiellen Aufbringen von Klebstoff auf Bauelemente zu schaffen, welche für eine Vielzahl von Bauelementen geeignet sind und ein Verrutschen von auf einem Bauelementeträger bestückten Bauelementen verhindern. Der Erfindung liegt ferner die Aufgabe zugrunde, eine Bestückvorrichtung zu schaffen, mittels welcher das erfindungsgemäße Verfahren effizient durchgeführt werden kann.

Die verfahrensbezogene Aufgabe wird gelöst durch ein Verfahren zum partiellen Aufbringen von Klebstoff auf Bauelemente mit den Merkmalen des unabhängigen Anspruchs 1.

Der Erfindung liegt die Erkenntnis zugrunde, dass ein Verrutschen von bestückten Bauelementen auf einem Bauelementeträger dadurch verhindert werden kann, dass ein Bauelement vor dem Bestücken lediglich an einer oder an mehreren Stellen mit Klebstoff versehen wird, welcher das Bauelement nach dem Bestücken zumindest solange exakt in seiner Bestückposition hält, bis das Bauelement mit dem Bauelementeträger verlötet ist und/oder bis ein zur Kontaktierung des Bauelements vorgesehener leitfähiger Klebstoff ausgehärtet ist.

Daraus ergibt sich, dass der Begriff Klebstoff in diesem Zusammenhang eine Vielzahl von pastenartigen Materialien wie beispielsweise, Lotpaste, Flussmittel, umfasst. Der Begriff Klebstoff umfasst aber auch sog. No Flow Underfill-Material.

Dieses wird typischerweise für ungehäuste Bauelemente verwendet, um eine mechanisch feste Verbindung zwischen Bauelement und Bauelementeträger zu gewährleisten, so dass durch unterschiedliche thermische Ausdehnungen von Bauelement und Bauelementeträger verursachte mechanische Spannungen aufgefangen werden können.

Gemäß Anspruch 2 kann auf eine Mehrzahl von Bauelementen innerhalb einer kurzen Zeit partiell Klebstoff transferiert werden, sofern von dem von dem Transfer-Element aufgenommenen Klebstoff jeweils nur ein Teil an ein Bauelement übertragen wird. Je kleiner dieser Teil ist, desto größer ist die Anzahl der Bauelemente, auf die bei einer einmaligen Klebstoffaufnahme durch das Transfer-Element Klebstoff partiell übertragen werden kann.

Das Verfahren nach Anspruch 3 ermöglicht eine sequentielle Bearbeitung von mehreren Bauelementen, so dass das Verfahren zum partiellen Aufbringen von Klebstoff auf vorteilhafte Weise in Bestückautomaten durchgeführt werden kann.

Die Verfahren nach Anspruch 4, Anspruch 5 und Anspruch 6 ermöglichen das Ausbilden einer homogenen Schichtdicke auf dem Trägerelement. Auf diese Weise kann eine definierte Klebstoffmenge auf das Bauelement übertragen werden und durch eine entsprechende Wahl der Schichtdicke der auf dem Trägerelement ausgebildeten Klebstoffschicht die Menge des auf das Bauelement zu übertragenden Klebstoffs bestimmt werden.

Die Weiterbildung nach Anspruch 7 erlaubt ein automatisches Nachfüllen von Klebstoff, so dass das Verfahren zum partiellen Aufbringen von Klebstoff ohne Unterbrechung für eine Vielzahl von Bauelemente durchgeführt werden kann. Das Aufbringen von Klebstoff kann dabei sowohl automatisch als auch manuell erfolgen.

Das Halten eines Bauelements an seiner dem Trägerelement abgewandten Seite gemäß Anspruch 8 erfolgt im allgemeinen mittels einer sog. Saugpipette.

Gemäß dem Verfahren nach Anspruch 9 werden mehrere über ein Hebeelement miteinander verbundene Transfer-Elemente zum Übertrag von Klebstoff an das Bauelement verwendet. Damit kann das Bauelement an mehreren Stellen gleichzeitig mit Klebstoff versehen werden. Die Anzahl der Transfer-Elemente, welche bevorzugt in einem Raster angeordnet sind, kann abhängig von der Größe, dem Gewicht und der Form des jeweiligen Bauelements gewählt werden.

Das Aufbringen von Klebstoff auf einer mit elektrischen Anschlüssen versehenen Seite des Bauelements gemäß Anspruch 10 wird insbesondere dann durchgeführt, wenn das jeweilige Bauelement sog. Anschlusskugeln aufweist, welche auf einer Unterseite des Bauelements flächig verteilt sind. Ebenso eignet sich das Verfahren nach Anspruch 10 für Wafer Level Underfilled Packages, welche an ihrer Unterseite zwischen ihren Anschlusskugeln eine vorgehärtete Klebstoffschicht aufweisen, die, wie oben erläutert, nach einem Heizvorgang eine mechanisch stabile Verbindung zwischen dem Package und dem entsprechenden Bauelementeträger gewährleistet.

Das Verfahren nach Anspruch 11 wird insbesondere bei sog. Bare Dies angewendet, bei welchen die elektrischen Anschlüsse auf einer Seite des Bauelements liegen, welche Seite bei einem bestückten Bare Die dem Bauelementeträger abgewandt ist.

Die erste vorrichtungsbezogene Aufgabe wird gelöst durch eine Vorrichtung zum partiellen Aufbringen von Klebstoff auf elektronische Bauelemente mit den Merkmalen des unabhängigen Anspruchs 12.

Die erfindungsgemäße Vorrichtung eignet sich insbesondere zur Durchführung des oben beschriebenen Verfahrens zum partiellen Aufbringen von Klebstoff auf elektronische Bauelemente. Als Transfer-Element wird bevorzugt ein länglicher Transfer-Stift verwendet, welcher entlang seiner Längsachse verschoben wird. Der Transfer-Stift kann beispielsweise eine zylindrische Form aufweisen, so dass der Transfer-Stift senkrecht zu seiner Längsachse eine kreisförmige Querschnittsfläche aufweist. In diesem Fall ist das Durchgangsloch bevorzugt eine Durchgangsbohrung, deren Durchmesser derart auf den Durchmesser des Transfer-Stiftes angepasst ist, dass einerseits eine freie Bewegung des Transfer-Stiftes entlang seiner Längsachse möglich ist und andererseits kein Klebstoff in den Spalt zwischen Transfer-Stift und Durchgangsbohrung gelangt. Es wird darauf hingewiesen, dass für den Transfer-Stift und das Durchgangsloch selbstverständlich auch andere Formen möglich sind.

Die Vorrichtungen nach Anspruch 13, Anspruch 14 und Anspruch 15 ermöglichen auf einfache Weise das Ausbilden einer Klebstoffschicht, die über die gesamte Trägerplatte verteilt eine gleichmäßige und genau definierte Schichtdicke aufweist. Auf diese Weise kann die Menge von auf das Bauelement zu übertragendem Klebstoff genau vorbestimmt werden.

Die Vorrichtung nach Anspruch 16 erlaubt ein automatisches Nachfüllen von Klebstoff auf das Trägerelement, falls die Menge des auf dem Trägerelement vorrätigen Klebstoffs beispielsweise nach dem partiellen Aufbringen von Klebstoff auf eine Mehrzahl von Bauelemente reduziert ist.

Die Vorrichtung nach Anspruch 17 ermöglicht auf vorteilhafte Weise einen Klebstofftransfer auf Bauelemente, wobei gleichzeitig eine Mehrzahl von Klebstoffpunkten auf das Bauelement aufgetragen wird. Die stiftförmigen Transfer-Elemente sind bevorzugt rasterförmig angeordnet, wobei die genaue Anordnung der Transfer-Elemente an die Beschaffenheit der jeweiligen Bauelemente angepasst werden kann. Neben der Anzahl an Transfer-Elementen kann auch diejenige Fläche an die Form der je weiligen Bauelemente angepasst werden, auf welcher Fläche die stiftförmigen Transfer-Elemente verteilt sind.

An dieser Stelle wird darauf hingewiesen, dass bei Verwendung von mehreren Transfer-Elementen das Bauelement derart angeordnet sein sollte, dass die entsprechende Oberfläche des Bauelements parallel zu derjenigen Ebene liegt, welche durch die Frontseite der Transfer-Stifte definiert ist.

Die zweite vorrichtungsbezogene Aufgabe wird gelöst durch eine Bestückvorrichtung zum Bestücken von Bauelementen mit den Merkmalen des unabhängigen Anspruchs 18.

Die Bestückvorrichtung nach Anspruch 19 hat den Vorteil, dass das partielle Aufbringen von Klebstoff auf ein Bauelement während eines Verfahrens des Bestückkopfes von einer Entnahmeposition einer Bauelement-Zuführeinrichtung hin zu einer Aufsetzposition auf den Bauelementeträger erfolgen kann und somit bei der automatischen Bestückung von Bauelementeträgern ein Zeitgewinn erzielt wird. Der Zeitgewinn besteht darin, dass der Bestückkopf nach der Aufnahme des Bauelements direkt zu der Aufsetzposition bewegt werden kann und ein Umweg über eine dritte Position vermieden wird, in welcher Position der Klebstoff auf das Bauelement aufgetragen wird.

Gemäß Anspruch 20 erfolgt das partielle Auftragen von Klebstoff in einer sog. Bearbeitungsstation eines Revolverkopfes.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1a, 1b, 1c und 1d: das partielle Auftragen von Klebstoff auf eine flächige Unterseite eines Wafer Level Underfilled-Bauelements und
- Figur 2a und 2b: das partielle Auftragen von Klebstoff auf flächige Bauelemente und das nachfolgende Bestücken der Bauelemente auf einem Bauelementeträger.

An dieser Stelle bleibt anzumerken, dass sich in der Zeichnung die Bezugszeichen einander entsprechender Komponenten lediglich in ihrer ersten Ziffer unterscheiden.

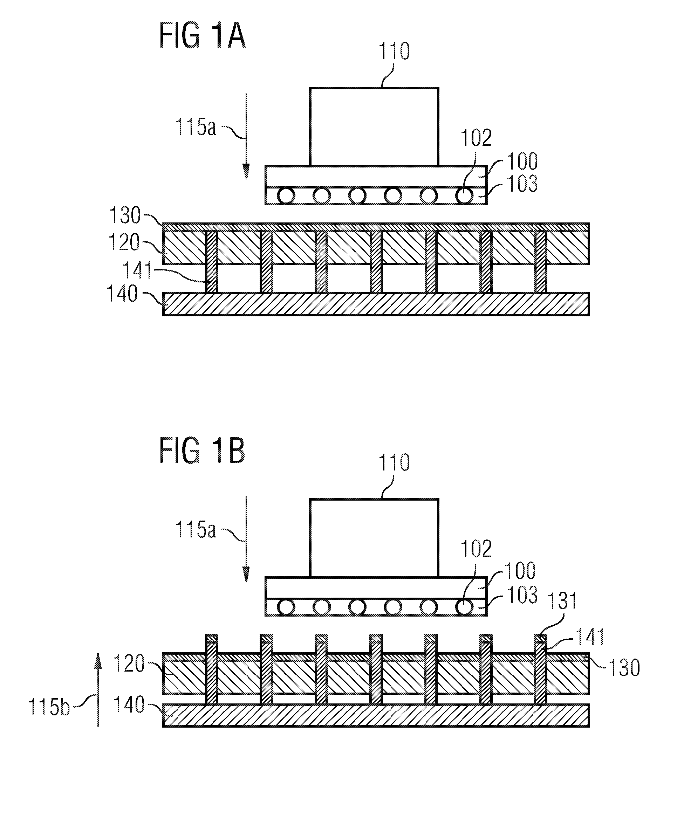

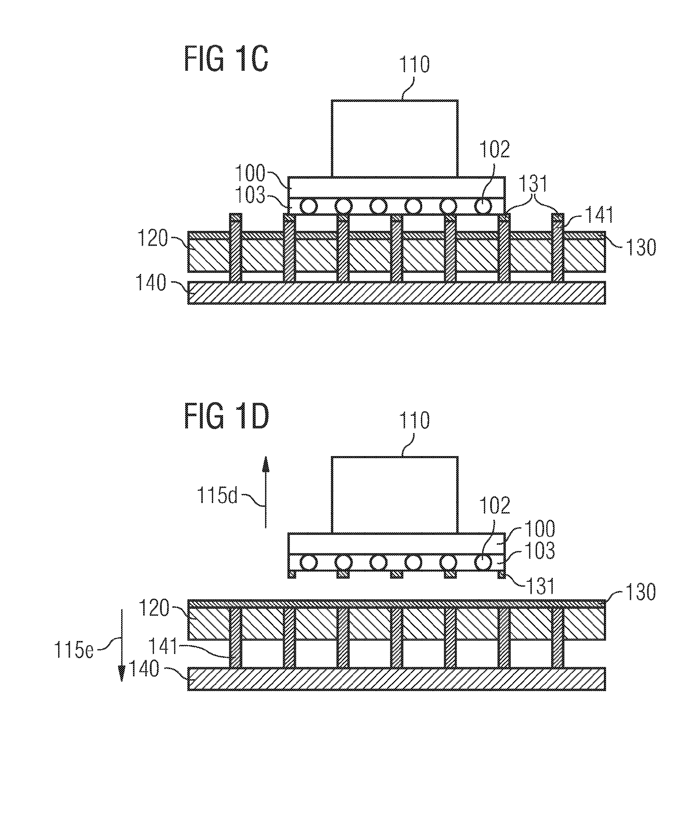

Figur 1a zeigt ein Bauelement 100, welches an seiner Unterseite Anschlüsse 102 und eine vorgehärtete Underfill-Klebstoffschicht 103 aufweist. Das Bauelement 100, welches als Wafer Level Underfilled-Package bezeichnet wird, wird von einer Haltevorrichtung 110 gehalten. Die Haltevorrichtung 110 ist beispielsweise eine sog. Saugpipette. Unterhalb des Bauelements 100 befindet sich eine Trägerplatte 120, auf welcher eine Klebstoffschicht 130 aufgetragen ist. Ferner ist ein Hebeelement 140 vorgesehen, an welchem sich Transfer-Stifte 141 befinden, die jeweils parallel zueinander und senkrecht zu der Oberfläche der Trägerplatte 120 ausgerichtet sind. Das Hebeelement 140 ist relativ zu der Trägerplatte 120 derart positioniert, dass die Spitzen der Transfer-Stifte 141 in einer Ebene mit der flächigen Oberseite der Trägerplatte 120 liegen, wobei die Transfer-Stifte 141 die Trägerplatte 120 durch entsprechend angeordnete Bohrungen in der Trägerplatte 120 durchdringen. Die Transfer-Stifte 141 sind über die Fläche der Trägerplatte 120 in einer regelmäßigen Anordnung verteilt. Die Klebstoffschicht 130 wurde im Vorfeld durch eine nicht dargestellte Nivelliervorrichtung nivelliert, so dass die Klebstoffschicht 130 eine im wesentlichen gleichmäßige Schichtdicke aufweist. Um das Bauelement 100 in die gewünschte Position zu bringen, wird die Haltevorrichtung relativ zu der Trägerplatte 120 entlang der Verschieberichtung 115a bewegt, wobei in der gewünschten Position der Abstand der Unterseite des Bauelements 100 zu der Klebstoffschicht 130 nicht größer als der Spalt zwischen der Unterseite der Trägerplatte 120 und der Oberseite des Hebeelements 140 ist.

Wie aus Figur 1b ersichtlich, wird nachfolgend das Hebeelement 140 entlang der Verschieberichtung 115b angehoben, so dass die Spitzen der Transfer-Stifte 141 die Klebstoffschicht 130 durchdringen und eine bestimmte Menge an Klebstoff 131 aufnehmen.

Wie aus Figur 1c ersichtlich, wird das Hebeelement 140 soweit nach oben bewegt, bis der Klebstoff 131, welcher sich an den Spitzen der Transfer-Stifte 141 befindet, die Unterseite des Bauelements, d.h. in diesem Fall die Underfill-Klebstoffschicht 103 bzw. eine Anschlusskugel 102 berührt. Auf diese Weise wird der Klebstoff 131 auf die Unterseite des Bauelements 100 zumindest teilweise transferiert.

Wie aus Figur 1d ersichtlich, wird nachfolgend die Haltevorrichtung 110 entlang der Verschieberichtung 115d nach oben bewegt. Dabei ist die Haltekraft, welche von der Haltevorrichtung 110 auf das Bauelement 100 ausgeübt wird, deutlich größer als die Klebekraft, welche durch den partiell aufgebrachten Klebstoff 131 zwischen der Unterseite des Bauelements 100 und den entsprechenden Transfer-Stiften 141 vermittelt wird. Da der Klebstoff 130 nur auf einer, verglichen mit der Fläche der Unterseite des Bauelements 100, kleinen Fläche aufgebracht ist, ist die Klebekraft zwischen dem Bauelement 100 und den Transfer-Stiften 141 im allgemeinen sehr klein.

Das partiell mit Klebstoff 131 versehene Bauelement 100 kann im folgenden auf einen Bauelementeträger (nicht dargestellt) bestückt werden, wobei der Klebstoff 131 dafür sorgt, dass die Bestückposition des Bauelements 100 auf dem Bauelementeträger auch bei einer ruckartigen Handhabung des bestückten Bauelementeträgers genau beibehalten wird. Das Bauelement 100 kann somit exakt an der Position verlötet werden, an der es zuvor bestückt wurde. Falls zur Kontaktierung des Bauelements ein sog. Leitkleber, d.h. ein elektrisch leitfähiger Klebstoff verwendet wird, dient der Klebstoff 131 dazu, dass das Bauelement 100 exakt in seiner Bestückposition verbleibt, bis der Leitkleber ausgehärtet ist oder bis die Festigkeit des Leitklebers so groß ist, dass ein Verrutschen des Bauelements ausgeschlossen ist.

Es wird darauf hingewiesen, dass der Transfer von Klebstoff 131 auch dadurch realisiert werden kann, dass zunächst durch eine entsprechende Verschiebung des Hebeelements 140 Klebstoff an den Frontseiten der Transfer-Stifte 141 aufgenommen wird, so dass je nach Anzahl der Transfer-Stifte 141 in einem bestimmten Abstand oberhalb der Trägerplatte 120 punktuell Klebstoff bereitgestellt wird. Erst danach wird das Bauelement 100 mit dem bereitgestellten Klebstoff in Kontakt gebracht. Dies hat den Vorteil, dass insbesondere wenn nur ein kleiner Teil des Klebstoffs auf das Bauelement transferiert wird, nacheinander auf eine Vielzahl von verschiedenen Bauelementen partiell Klebstoff aufgetragen werden kann, ohne dass die Transfer-Stifte 141 zur erneuten Aufnahme von Klebstoff relativ zu der Trägerplatte 120 abgesenkt und wieder angehoben werden müssen.

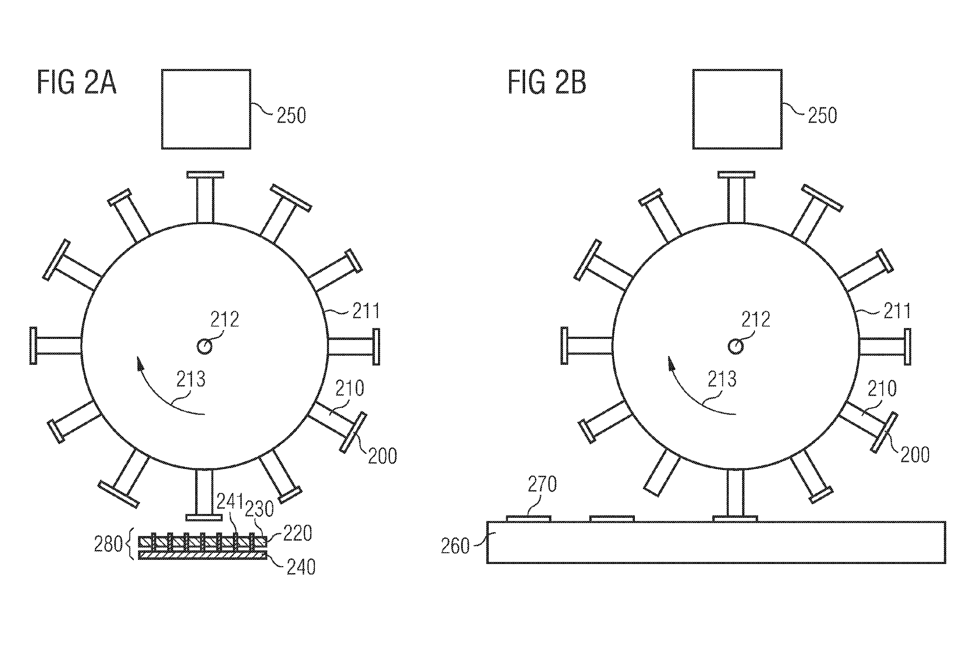

Die Figuren 2a und 2b zeigen das partielle Aufbringen von Klebstoff auf Bauelemente 200 und das nachfolgende Bestücken der Bauelemente 200 auf einen Bauelementeträger 260. Die Bestückung erfolgt mittels eines sog. Revolverkopfes 211, welcher eine Mehrzahl von sternförmig angeordneten Haltevorrichtungen 210 aufweist, die um eine Drehachse 212 herum entlang einer Drehrichtung 213 drehbar sind. Relativ zu der Drehachse 212 ist eine Kamera 250 derart angeordnet, dass Bauelemente 200, welche sich im Gesichtsfeld der Kamera 250 befinden, optisch erfasst werden können. Dabei können beispielsweise defekte Bauelemente 200 erkannt und aus dem Bestückprozess entfernt werden. Ferner dient die Kamera 250 dazu, die Lage der jeweils erfassten Bauelemente 200 zu erfassen. Somit kann beispielsweise durch eine Drehung der entsprechenden Haltevorrichtung 210 um ihre Längsachse die Winkellage des Bauelements 200 relativ zu der Drehachse 212 variiert werden.

Der Revolverkopf 211 wird mittels einer nicht dargestellten Positioniervorrichtung derart positioniert, dass bei einer getakteten Drehbewegung des Revolverkopfes 211 um die Drehachse 212 sämtliche von den Haltevorrichtungen 210 gehaltenen Bauelemente 200 sequentiell in den Behandlungsbereich einer Vorrichtung 280 transportiert werden, mittels der die Unterseite der Bauelemente 200 partiell mit Klebstoff versehen werden. Die Vorrichtung 280 umfasst eine Trägerplatte 220, an welcher sich eine Klebstoffschicht 230 befindet. Die Vorrichtung 280 umfasst ferner ein Hebeelement 240, an welchem sich eine Mehrzahl von Transfer-Stiften 241 befinden, welche die Trägerplatte 220 durch entsprechende Bohrungen durchdringen. Das partielle Aufbringen von Klebstoff auf die Unterseite der Bauelemente 200 erfolgt auf die gleiche Weise, wie es bereits oben anhand der Figuren 1a, 1b, 1c und 1d beschrieben wurde.

Nach dem sequentiellen Behandeln von einer Mehrzahl von Bauelementen 200, wobei jeweils Klebstoff partiell auf die Unterseite der Bauelemente 200 aufgebracht wurde, wird der Revolverkopf 211 derart verfahren, dass bei einer getakteten Drehung des Revolverkopfes 211 und einer entsprechenden Aufwärts- und Abwärtsbewegung der Haltevorrichtung 210 die partiell mit Klebstoff versehenen Bauelemente 200 auf dem Bauelementeträger 260 aufgesetzt werden. Ein bestücktes Bauelement ist in Figur 2b mit dem Bezugszeichen 270 versehen.

Es wird darauf hingewiesen, dass das partielle Aufbringen von Klebstoff auf die Unterseite der Bauelemente 200 nicht unbedingt bei einer Winkelstellung des Revolverkopfes 211 erfolgen muss, in der die entsprechende Haltevorrichtung senkrecht nach unten gerichtet ist. So kann beispielsweise die Vorrichtung 280 zum partiellen Aufbringen von Klebstoff derart angeordnet sein, dass diejenigen Bauelemente, welche gerade von einer horizontal ausgerichteten Haltevorrichtung 210 gehalten werden, partiell mit Klebstoff versehen werden. Dabei ist zu beachten, dass ein Klebstoff mit einer bestimmten Viskosität verwendet wird, so dass die Klebstoffschicht 230 trotz des Einflusses der Schwerkraft eine weitgehend gleichmäßige Dicke beibehält.

Das Anordnen der Vorrichtung 280 zum partiellen Aufbringen von Klebstoff auf Bauelemente in einer Position, die unterschiedlich zu der in Figur 2a dargestellten Position ist, hat den Vorteil, dass die Vorrichtung 280 ebenso wie die Kamera 250 in einer relativ zu der Drehachse 212 ortsfesten Position angeordnet sein kann. In diesem Fall stellt die Vorrichtung 280 zum partiellen Aufbringen von Klebstoff ebenso wie die Kamera 250 eine sog. Bearbeitungsstation dar, durch welche die Bauelemente 200 bei einer entsprechenden Drehung des Revolverkopfes 211 durchgetaktet werden. Dabei kann die Vorrichtung 280 derart angeordnet sein, dass ein zu bestückendes Bauelement 200 kurz vor dem Aufsetzen auf den Bauelementeträger 230 partiell mit Klebstoff versehen wird. Dies hat den Vorteil, dass die Zeitspanne zwischen dem partiellen Aufbringen des Klebstoffs auf die Unterseite des Bauelements 200 und dem Aufsetzen des Bauelements 200 auf den Bauelementeträger 360 sehr kurz sein kann.

Es wird darauf hingewiesen, dass die Erfindung auch auf vorteilhafte Weise bei einem Aufeinanderbestücken von mehreren Bare Dies (sog. Chip Stacking) eingesetzt werden kann, wobei durch eine schichtweise Anordnung von mehreren Bare Dies zur Steigerung der Packungsdichte von Elektronik-Endprodukten auch die Richtung senkrecht zu der Oberfläche eines Bauelementeträgers ausgenutzt werden kann.

Zusammenfassend schafft die Erfindung ein Verfahren und eine Vorrichtung zum partiellen Aufbringen von Klebstoff auf Bauelemente, insbesondere auf elektronische Bauelemente wie Flip Chips und/oder Ball Grid Arrays. Gemäß der Erfindung wird zumindest ein Transfer-Element 141 verwendet, welches zunächst eine Klebstoffschicht 130, die auf einem Trägerelement 120 ausgebildet ist, durchdringt und dabei an seiner Frontseite Klebstoff 131 aufnimmt. Bei einer Berührung zwischen einem Bauelement 100 und dem Transfer-Element 141 wird zumindest ein Teil des zuvor aufgenommenen Klebstoffs 131 auf das Bauelement 100 übertragen. Gemäß einem vorteilhaften Ausführungsbeispiel der Erfindung werden eine Mehrzahl von als Stifte ausgebildete Transfer-Elemente 141 eingesetzt, so dass Klebstoff 131 gleichzeitig an verschiedenen Stellen auf ein Bauelement 100 übertragen werden kann. Die Erfindung schafft ferner eine Bestückvorrichtung zum Bestücken von Bauelementen 200, bei der die Bauelemente 200 zunächst mittels einer Vorrichtung 280 zum partiellen Aufbringen von Klebstoff behandelt und nachfolgend auf einem Bauelementeträger 260 aufgesetzt werden.

## Patentansprüche

1. Verfahren zum partiellen Aufbringen von Klebstoff auf Bauelemente, insbesondere auf elektronische Bauelemente wie Flip Chips und/oder Ball Grid Arrays, bei dem
• ein Trägerelement (120) verwendet wird, an welchem sich auf einer flächigen Seite Klebstoff (130) befindet,
• mindestens ein Transfer-Element (141), welches sich in einer Ausgangslage zumindest teilweise in einem Durchgangsloch des Trägerelements (120) befindet, aus der Ausgangslage heraus derart bewegt wird, dass das Transfer-Element (120) an seiner Frontseite beim Durchdringen durch den Klebstoff (130) zumindest einen Teil des Klebstoffs (131) aufnimmt,
• ein Bauelement (100) mit dem aufgenommenen Klebstoff (131) in Kontakt gebracht wird, so dass zumindest ein Teil des aufgenommenen Klebstoffs (131) auf das Bauelement (100) übertragen wird.

2. Verfahren nach Anspruch 1, bei dem nach dem Übertragen eines Teils des aufgenommenen Klebstoffs (131) auf das Bauelement (100)
• das Bauelement (100) von dem Transfer-Element (141) entfernt wird und
• ein weiteres Bauelement mit noch an der Frontseite verbliebenem Klebstoff (131) in Kontakt gebracht wird, so dass erneut zumindest ein Teil des aufgenommenen Klebstoffs (131) auf das Bauelement (100) übertragen wird.

3. Verfahren nach einem der Ansprüche 1 bis 2, bei dem nach dem Übertragen des Klebstoffs (131) auf einen oder auf eine Mehrzahl vom Bauelementen (100) das Transfer-Element (141) wieder in seine Ausgangslage gebracht wird.

4. Verfahren nach einem der Ansprüche 1 bis 3, bei dem als Trägerelement (120) eine Trägerplatte verwendet wird, auf welcher der Klebstoff (130) in Form einer Klebstoffschicht flächig aufgetragen ist.

5. Verfahren nach Anspruch 4, bei dem die Ausgangslage des Transfer-Elements (141) dadurch bestimmt wird, dass die Frontseite des Transfer-Elements (141) in einer Ebene mit der mit Klebstoff versehenen Seite der Trägerplatte (120) liegt.

6. Verfahren nach Anspruch 5, bei dem vor dem Bewegen des Transfer-Elements (141) die Klebstoffschicht (130) nivelliert wird.

7. Verfahren nach Anspruch 6, bei dem vor dem Nivellieren der Klebstoffschicht (130) mittels einer Dispensiervorrichtung eine bestimmte Menge an Klebstoff auf die Trägerplatte (120) gebracht wird.

8. Verfahren nach einem der Ansprüche 1 bis 7, bei dem das Bauelement (100) an seiner dem Trägerelement (120) abgewandten Seite von einer Haltevorrichtung (110) gehalten wird.

9. Verfahren nach einem der Ansprüche 1 bis 8, bei dem mehrere über ein Hebeelement (140) miteinander verbundene Transfer-Elemente (141) verwendet werden, welche jeweils Klebstoff (131) an das Bauelement (100) übertragen.

10. Verfahren nach einem der Ansprüche 1 bis 9, bei dem der Klebstoff (131) auf eine Seite des Bauelements (100) aufgebracht wird, an welcher sich elektrische Anschlüsse befinden.

11. Verfahren nach einem der Ansprüche 1 bis 9, bei dem der Klebstoff (131) auf eine Seite des Bauelements (100) aufgebracht wird, ab welcher sich keine elektrischen Anschlüsse befinden.

12. Vorrichtung zum partiellen Aufbringen von Klebstoff auf Bauelemente, insbesondere auf elektronische Bauelemente wie Flip Chips und/oder Ball Grid Arrays, mit
• einem Trägerelement (120), auf welchem auf einer Seite Klebstoff (130) aufbringbar ist,
• einem Durchgangsloch, welches in dem Trägerelement (120) ausgebildet ist,
• zumindest einem Transfer-Element (141), welches sich in einer Ausgangslage zumindest teilweise in dem Durchgangsloch des Trägerelements (120) befindet, und
• einem Hebeelement (140), welches mit dem Transfer-Element (141) verbunden ist und welches relativ zu dem Trägerelement (120) bewegbar ist, so dass das Transfer-Element (141) aus der Ausgangslage heraus derart bewegt wird, dass das Transfer-Element (141)
- an seiner Frontseite beim Durchdringen durch den Klebstoff (130) zumindest einen Teil des Klebstoffs (131) aufnimmt und
- bei einem Kontakt mit einem Bauelement (100) zumindest einen Teil des aufgenommenen Klebstoffs (131) an das Bauelement (100) überträgt.

13. Vorrichtung nach Anspruch 12, bei der das Trägerelement (120) eine Trägerplatte ist, auf welcher der Klebstoff (130) in Form einer Klebstoffschicht auftragbar ist.

14. Vorrichtung nach Anspruch 13, bei der die Ausgangslage des Transfer-Elementes (141) dadurch bestimmt ist, dass die Frontseite des Transfer-Elementes (141) in einer Ebene mit der Seite der Trägerplatte (120) liegt, auf welche die Klebstoffschicht (130) auftragbar ist.

15. Vorrichtung nach Anspruch 14, zusätzlich mit
einer Nivelliervorrichtung, mittels welcher die Klebstoffschicht (130) nivellierbar ist.

16. Vorrichtung nach einem der Ansprüche 12 bis 15, zusätzlich mit
einer Dispensiervorrichtung, mittels welcher eine bestimmte Menge an Klebstoff auf das Trägerelement (120) aufbringbar ist.

17. Vorrichtung nach einem der Ansprüche 12 bis 16, mit
einer Mehrzahl von stiftförmigen Transfer-Elementen (141), welche parallel zueinander angeordnet und über das Hebeelement (140) miteinander verbunden sind.

18. Bestückvorrichtung zum Bestücken von Bauelementen, insbesondere flächige elektronische Bauelemente wie Flip Chips und/oder Ball Grid Arrays, auf einem Bauelementeträger, mit
• einem Bestückkopf (211), mit welchem Bauelemente (200) von einer Entnahmeposition einer Bauelement-Zuführeinrichtung hin zu einer Aufsetzposition auf dem Bauelementeträger (260) transportierbar sind, und
• einer Vorrichtung (280) zum partiellen Aufbringen von Klebstoff auf elektronische Bauelemente nach einem der Ansprüche 12 bis 17.

19. Bestückvorrichtung nach Anspruch 18, bei welcher
die Vorrichtung (280) relativ zu dem Bestückkopf (211) in einer festen räumlichen Position angeordnet oder relativ zu dieser festen räumlichen Position herum positionierbar ist.

20. Bestückvorrichtung nach einem der Ansprüche 18 bis 19, bei welcher
der Bestückkopf (211) eine Mehrzahl von Haltevorrichtungen (210) aufweist, die sternförmig angeordnet und um eine Achse (212) herum drehbar sind.
